(19) Europäisches Patentamt
European Patent Office
Office européen des brevets

(11) **EP 1 032 133 A1**

(12) **EUROPÄISCHE PATENTANMELDUNG**

(43) Veröffentlichungstag:
**30.08.2000 Patentblatt 2000/35**

(51) Int. Cl.[7]: **H03L 7/08**

(21) Anmeldenummer: **00102996.6**

(22) Anmeldetag: **14.02.2000**

(84) Benannte Vertragsstaaten:
**AT BE CH CY DE DK ES FI FR GB GR IE IT LI LU MC NL PT SE**
Benannte Erstreckungsstaaten:
**AL LT LV MK RO SI**

(30) Priorität: **23.02.1999 DE 19907756**

(71) Anmelder:
**SIEMENS AKTIENGESELLSCHAFT
80333 München (DE)**

(72) Erfinder:
• **Trimmel, Herwig
  82178 Puchheim (DE)**
• **Thanhäuser, Gerhard
  86415 Mering (DE)**
• **Stummer, Baldur
  81543 München (DE)**

(54) **Phasenregelkreis mit geringem Phasenfehler**

(57) Ein Phasenregelkreis zur Regelung der Phase eines Ausgangssignals S2 in Abhängigkeit von einem Referenzsignal S1 mit geringem Phasenzeitfehler weist eine Abtastschaltung (2; 13) zur Abtastung des Referenzsignals S1 durch das Ausgangssignal S2 und zur Erzeugung eines Abtastsignals S1A, eine Jitter-Modulationsschaltung (3) zur Erzeugung eines um eine festgelegte Zeitdauer verzögerten Abtastsignals S1AJ und zur abwechselnden Ausgabe des unverzögerten Abtastsignals S1A und des verzögerten Abtastsignals S1AJ, einen Phasendetektor (6) zur Erfassung einer mittleren Phasendifferenz zwischen dem Ausgangssignal S2 und den verzögerten und unverzögerten Abtastsignalen S1A und S1AJ und einen regelbaren Oszillator (11) zur Erzeugung des Ausgangssignals S2 mit einer in Abhängigkeit von der durch den Phasendetektor (6) erfaßten mittleren Phasendifferenz regelbaren Frequenz auf.

FIG 1

**Beschreibung**

Die Erfindung betrifft einen Phasenregelkreis zur Regelung der Phase eines Ausgangssignals S2 in Abhängigkeit von einem Referenzsignal S1.

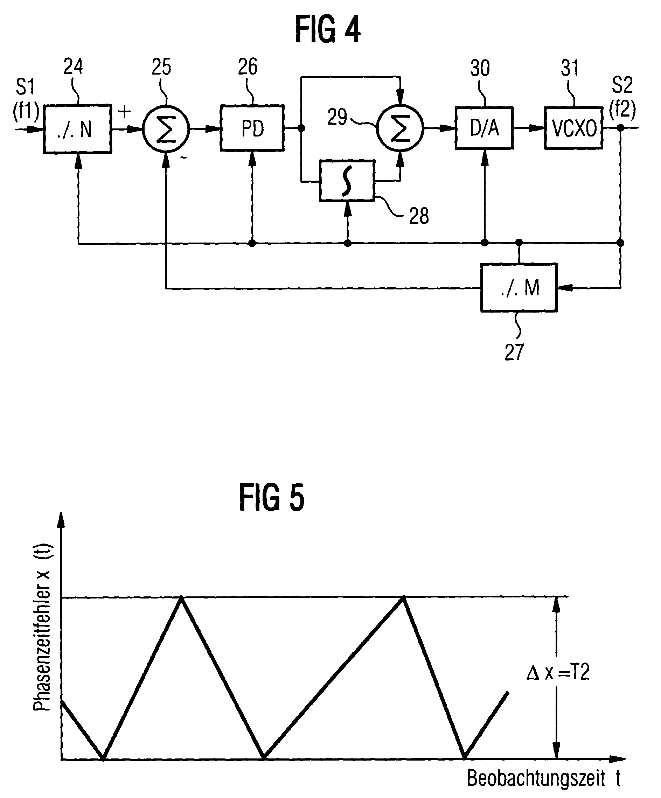

Figur 4 zeigt ein Blockschaltbild eines bekannten derartigen digitalen Phasenregelkreises (PLL, Phase Locked Loop). Die Phasenlage des Ausgangssignals S2 mit der Frequenz f2 wird durch Vergleich in einem Phasendetektor 26 auf die Phasenlage des Referenzsignals S1 mit der Frequenz f2 geregelt. Dabei ist die Nachregelung des Ausgangssignals S2 jedoch nicht fehlerfrei. Der Phasenzeitfehler x(t), d. h. die Phasendifferenz zwischen dem Referenzsignal S1 und dem Ausgangssignal S2, ist bei digitalen Phasenregelkreisen durch die Periodendauer oder Quantisierungsstufe $T2 = 1/f2$ des Ausgangssignals S2 gegeben, welches auch als Taktfrequenz der digitalen Komponenten wie der Dividierer 24, 27, des Phasendetektors 26 des Integrators 28 und des Digital/Analog-Wandlers 30 verwendet wird, wie in Figur 4 durch Pfeillinien angedeutet ist.

Im folgenden wird der Mechanismus der Entstehung eines Phasenzeitfehlers bei dem in Figur 4 gezeigten Phasenregelkreis anhand der Figuren 5 und 6 erläutert.

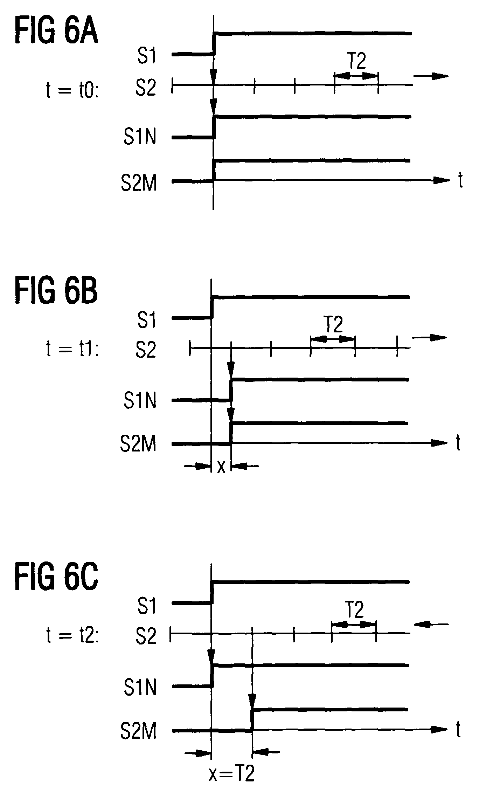

Figur 6 zeigt die Phasenlagen der Signale S2, S2M (durch M geteiltes Ausgangssignal am Eingang des Phasendetektors) und S2N (durch N geteiltes Referenzsignal am Eingang des Phasendetektors) relativ zum Referenzsignal S1 zu verschiedenen, aufeinanderfolgenden Zeitpunkten t0 (Figur 6a), t1 (Figur 6b) und t2 (Figur 6c). Dabei ist eine geringfügig höhere Eigenfrequenz (voreilende Phasenlage) des Quarzoszillators 31 vorausgesetzt. Das (höherfrequente) Signal S2 tastet dabei mit einer Periode $T2 = 1/f2$ die Phasenlage des Referenzsignals S1 ab (in den Figuren 6a bis 6c durch einen vertikalen Pfeil symbolisiert). Übersteigt die Phasenverschiebung der Signale S1 und S2 zueinander die Periodendauer T2, so wird diese vom Phasendetektor 26 erfaßt und der spannungsgesteuerte Oszillator 31 mittels des Integrators 28, der Summierschaltung 29 und des Digital/Analog-Wandlers 30 gesteuert, die Frequenz des Signals entsprechend nachzuführen, so daß die Phasenverschiebung zwischen S1 und S2 weggeregelt wird. Innerhalb der Periodendauer T2 ist die Anbindung der zueinander synchronen Signale S1N, S2M und S2 an das Referenzsignal S1 jedoch aufgehoben. Diese Totzeit entsteht prinzipiell durch das Abtasten des Referenzsignals S1 durch das Oszillatorsignal S2. Eine Drift des Oszillators 31 wird innerhalb der Totzeit T2 so nicht nachgeregelt und greift voll auf das Ausgangssignal S2 durch. Erst bei einem Phasenzeitfehler $x = T2$ wird die Phasendifferenz vom Phasendetektor 26 erfaßt und die Frequenz des Oszillators 31 entsprechend nachgeregelt. So tritt ein zeitabhängiger Phasenzeitfehler x(t) mit einem Maximalwert $\Delta x = T2$ auf, dessen typischer zeitlicher Verlauf in Figur 5 dargestellt ist. Man erkennt einen typischen dreieck- bzw. sägezahnförmigen Verlauf, der zuerst durch die Drift des Oszillators in voreilende Richtung bestimmt ist. Erreicht der Fehler x(t) die Schwelle T2, wird eine geringe Nachziehspannung erzeugt, die die Frequenz des Oszillators 31 verringert. Der Fehler x(t) wird nun wieder kleiner bis zum Phasendetektor 26 keine Phasendifferenz mehr erfaßt wird und die Nachziehspannung am Oszillator daraufhin verschwindet.

Figur 6b zeigt die Situation, wenn ein Phasenzeitfehler $0 \leq x \leq T2$ zwischen dem Signal S1 einerseits und den zueinander synchronen Signalen S2, S1N und S1M andererseits besteht. Wächst der Phasenzeitfehler weiter, bis $x = T2$ erreicht ist (Figur 6c), erfaßt die Abtastung durch das Signal S2 die veränderte Phasenlage und der Oszillator wird entsprechend nachgeregelt.

Für bestimmte Anwendungen wie etwa Taktaufbereitungsschaltungen in synchronen digitalen Kommunikationsnetzen ist ein möglichst kleiner Phasenzeitfehler vorteilhaft.

Es ist bekannt, den Phasenzeitfehler x(t) durch die Verwendung von hochfrequenten nachgeführten regelbaren Oszillatoren zu vermindern und damit eine hohe Frequenz des Signals S2 zu erreichen. Dieses Verfahren hat jedoch den Nachteil, daß der Ziehbereich eines spannungsgesteuerten Quarzoszillators (VCXO) mit dem Quadrat des verwendeten Obertons des Quarzoszillators abnimmt. D. h., je höher die Betriebsfrequenz des Quarzoszillators im Verhältnis zur Grundschwingung desselben ist, desto kleiner wird der Regelbereich der Oszillatorfrequenz. Außerdem müssen bei der Verwendung einer höheren Frequenz des Ausgangssignals S2 die digitalen Komponenten des Phasenregelkreises mit schnellen Logikschaltungen realisiert werden, wodurch deren Kosten und Leistungsaufnahme zunehmen. Wegen der hohen Zahl von synchron getakteten Flipflops in Zählern bzw. Teilern liegt die Betriebsfrequenz erheblich niedriger als die Grenzfrequenz beispielsweise eines Flipflops. In einem Beispiel mit 500 synchronen Flipflops konnte mit 0,5 μm-CMOS-Technologie (ASIC) nur eine Betriebsfrequenz von 50 MHz, was einem Phasenzeitfehler von ungefähr 20 ns entspricht, erreicht werden.

Der vorliegenden Erfindung liegt daher die Aufgabe zugrunde, einen Phasenregelkreis mit geringerem Phasenfehler vorzuschlagen.

Gelöst wird die Aufgabe erfindungsgemäß durch einen Phasenregelkreis mit einer Abtastschaltung zur Abtastung des Referenzsignals S1 durch das Ausgangssignal S2 und zur Erzeugung eines Abtastsignals S1A, einer Jitter-Modulationsschaltung zur Erzeugung eines um eine festgelegte Zeitdauer verzögerten Abtastsignals S1AJ und zur abwechselnden Ausgabe des unverzögerten Abtastsignals S1A und des verzögerten Abtastsignals S1AJ, einem Phasendetektor zur Erfassung einer mittleren Phasendifferenz zwischen dem Ausgangssignal S2 und den verzögerten und unverzögerten Abtastsignalen S1A und S1AJ und einem regelbaren Oszillator zur Erzeugung des Ausgangssignals S2 mit einer in Abhängigkeit von der durch den Phasendetektor erfaßten mittleren Phasendifferenz regelbaren Frequenz. Durch die Mittelung werden auch Phasenverschiebungen zwischen dem Referenzsignal S1 und dem Ausgangssignal S2 für den Phasendetektor "spürbar", die innerhalb einer Abtastperiode des Signals S2 liegen. So kann der Phasenzeitfehler wesentlich verringert werden. Vorteilhafte Ausgestaltungen des erfindungsgemäßen Phasenregelkreises sind in den Unteransprüchen angegeben.

Die Jitter-Modulationsschaltung weist vorzugsweise eine Verzögerungsschaltung wie beispielsweise ein D-Flipflop zur Erzeugung eines verzögerten Referenzsignals S1AJ und eine Schalteinrichtung zur abwechselnden Zuführung des verzögerten Signals S1AJ und des unverzögerten Signals S1A zum Phasendetektor auf. Die Schalteinrichtung kann vorzugsweise als Digital-Mulitplexer ausgebildet sein.

Die durch die Verzögerungsschaltung erzeugte Signalverzögerung entspricht vorzugsweise einer Periodendauer T2 des Ausgangssignals S2.

Die Schaltfrequenz der Schalteinrichtung ist groß im Verhältnis zur Übertragungsfunktion des Phasenregelkreises gewählt, so daß das Schaltsignal von der Schalteinrichtung im Ausgangssignal weitgehend unterdrückt ist, so daß keine durch die Jittermodulation hervorgerufenen Störungen im Ausgangssignal auftreten.

Der erfindungsgemäße Phasenregelkreis kann einen ersten Frequenzdividierer zur Frequenzdivision des Referenzsignals S1 vor Zuführung zum Phasendetektor durch N und einen zweiten Frequenzdividierer zur Frequenzdivision des Ausgangssignals S2 vor Zuführung zum Phasendetektor durch M aufweisen. So können mit dem Phasenregelkreis Signale S1, S2 unterschiedlicher Frequenz in feste Phasenbeziehung gebracht werden.

Die Schaltperiode der Schalteinrichtung beträgt dabei vorzugsweise 2N mal der Taktperiode t2 des Ausgangssignals S2.

Um eine symmetrische Phasen-Feinregelung zu erleichtern, beträgt das Tastverhältnis des von der Schalteinrichtung erzeugten unverzögerten Signals S1A und des verzögerten Signals S1AJ vorzugsweise 1:1.

Die erfindungsgemäße Schaltung wird vorzugsweise durch rein digitale Komponenten realisiert, wobei mit einer geringen Anzahl von Gattern eine zuverlässige Phasen-Feinregelung ermöglicht wird.

Die Erfindung wird im folgenden anhand von bevorzugten Ausführungsbeispielen unter Bezugnahme auf die Zeichnungen im Detail erläutert, in denen

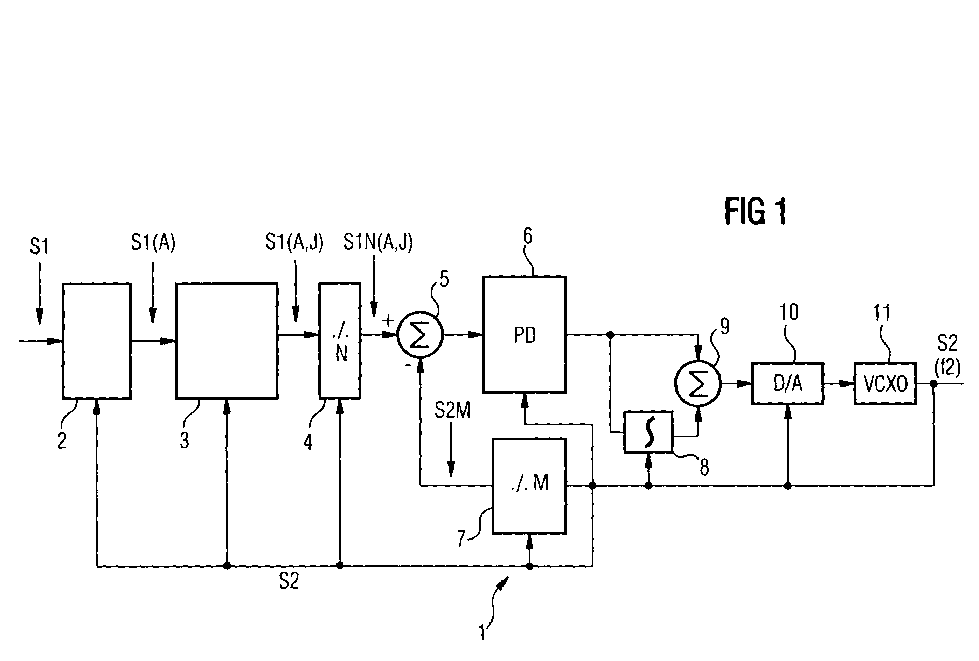

Figur 1 ein Blockschaltbild eines ersten Ausführungsbeispiels des erfindungsgemäßen Phasenregelkreises zeigt;

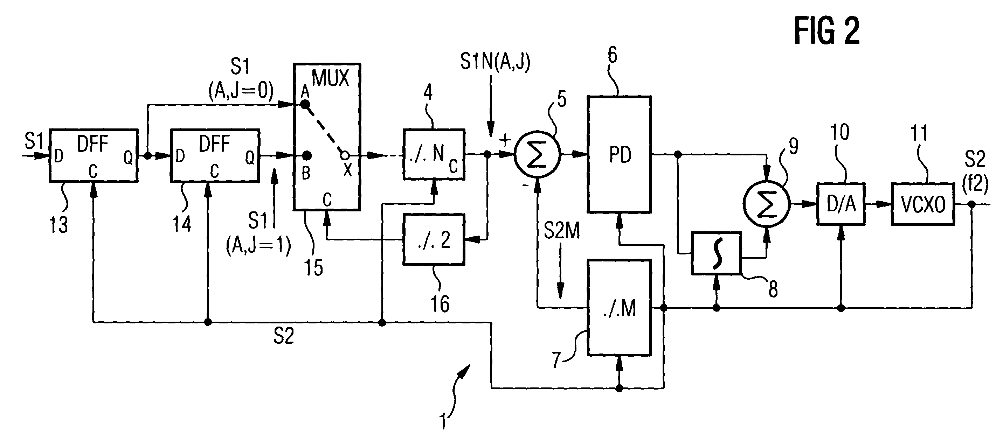

Figur 2 ein Blockschaltbild eines modifizierten Ausführungsbeispiels des erfindungsgemäßen Phasenregelkreises zeigt;

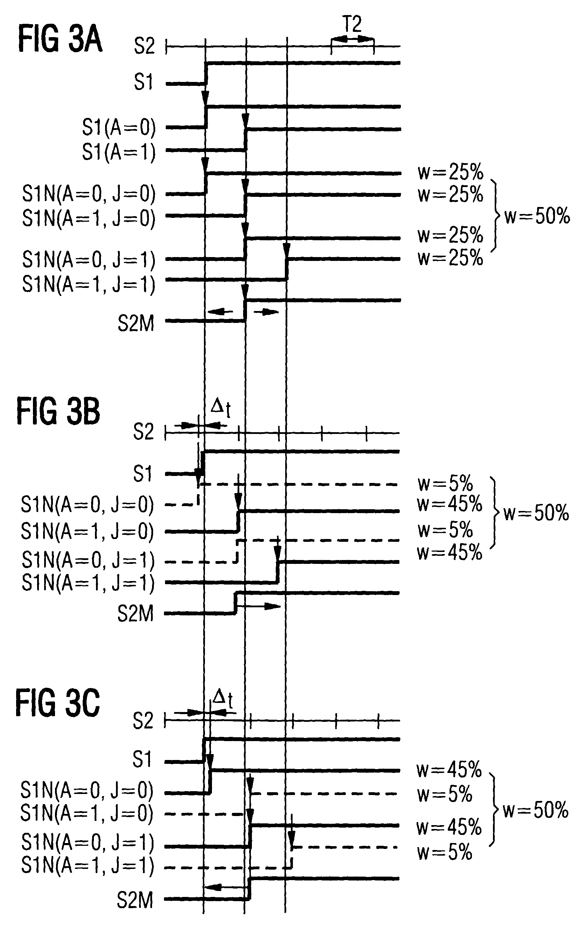

Figur 3 Signal-Zeitablaufdiagramme zur Erläuterung der Funktionsweise des Phasenregelkreises der Figuren 1 oder 2 zeigt;

Figur 4 ein Blockschaltbild eines bekannten Phasenregelkreises zeigt;

Figur 5 ein Diagramm zur Erläuterung der Entstehung eines Phasenzeitfehlers bei dem Phasenregelkreis von Figur 4 ist; und

Figur 6 ein Signal-Zeitablaufdiagramm zur Erläuterung der Entstehung eines Phasenzeitfehlers bei dem Phasenregelkreis von Figur 4 zeigt.

Figur 1 zeigt ein Blockschaltbild eines erfindungsgemäßen Phasenregelkreises. Die Bauelemente im rechten Teil der Schaltung, d. h. der Dividierer 4, der Addierer 5, der Phasendetektor 6, der Dividierer 7, der Integrator 8, der Addierer 9, der Digital/Analog-Wandler 10 und der spannungsgesteuerte Oszillator 11 entsprechen den jeweiligen Bauelementen der Schaltung von Figur 4. Bevor das Signal S1 in dem Dividierer 4 durch N geteilt wird, wird es mittels einer von dem Signal S2 angesteuerten Abtastschaltung 2 abgetastet und anschließend durch die Jitter-Modulationsschaltung 3 moduliert. Das modulierte Signal S1 (A, J) wird durch N dividiert und das daraus resultierende Signal S1N (A, J) dem Addierer 5 zugeführt, dem auch das durch M dividierte Ausgangssignal S2 zugeführt wird. Der Phasendetektor 6, der ebenfalls durch das Signal S2 getaktet ist, erfaßt die Phasendifferenz zwischen den Signalen S1N (A, J) und S2M und steuert entsprechend über den Integrator 8, den Addierer 9 und den Digital/Analog-Wandler 10 den spannungsgesteuerten Oszillator 11, die erfaßte Phasendifferenz zu minimieren.

Die Funktionsweise der Jitter-Modulationsschaltung 3 wird im folgenden anhand von Figur 3 erläutert. Figur 3a zeigt die Phasenlagen im stationären Zustand, d. h. wenn S1 und S2 in Phase sind. Die positive Flanke des Ausgangssignals S2 ist auf die positive Flanke des Referenzsignals S1 geregelt. Die Abtastung von S1 erfolgt mit dem Taktsignal S2. Da die Flanken von S1 und S2 übereinstimmen, werden durch die Abtastschaltung 2 fluktuierend ein nicht verzögertes Signal S1 (A=0) erzeugt, wenn die Taktflanke knapp nach der Signalflanke S1 liegt bzw. das um T2 verzögerte Signal S1 (A=1) erzeugt, wenn die Taktflanke S2 knapp vor der Signalflanke S1 liegt. Im stationären Zustand tastet die Abtastschaltung 2 so das Signal S1 einmal kurz vor der Signalflanke und einmal kurz nach der Signalflanke ab, so daß das unverzögerte Signal S1 (A=0) und S1 (A=1) jeweils mit 50% Wahrscheinlichkeit auftreten.

Die Jitter-Modulationsschaltung 3 erzeugt aus dem Signal S1A mit jeweils 50% Tastverhältnis die Signale S1 (A, J = 0) und S1 (A, J = 1). Im Fall J=1 wird die Laufzeit einer Taktperiode T2 addiert, während im Fall J=0 keine Verzögerung erzeugt wird. Die Umschaltperiode kT2 wird vorzugsweise zu k=2N so gewählt, daß nach dem Eingangsteiler N beide Fälle abwechselnd aufeinander folgen. In dem dem Dividierer N zugeführten Signal S1 (A, J) sind so 3 Phasenlagen enthalten:

Flanke t = 0:     S1 (A=0, J=0), w=25%
Flanke t = T2:    S1 (A=0, J=1), w=25%
                  S1 (A=1, J=0), w=25%
Flanke t = 2T2:   S1 (A=1, J=1), w=25%

Aus dem Signal S1 (A, J) wird dann mit Hilfe des synchronen Teilers 4 das durch N frequenzdividierte Signal S1N (A, J) erzeugt. Durch Vergleich mit dem durch M frequenzdividierten Ausgangssignal S2M wird am Phasendetektor eine zur mittleren Phasendifferenz proportionale Steuerspannung für den Oszillator 11 erzeugt. Für den stationären Fall wird S2M auf den mittleren Wert t=T2 geregelt. Die beiden Grenzfälle t=0 und t=2T2 erzeugen Steuerspannungen entgegengesetzter Polarität, die sich im Mittel gegenseitig aufheben, so daß die Frequenz des spannungsgeregelten Oszillators 11 konstant bleibt. Dabei ist die Jitterfrequenz größer als die Grenzfrequenz der Jitter-Übertragungsfunktion des Phasenregelkreises gewählt, so daß die Jitter-Signale im Ausgangssignal S2 unterdrückt sind. Die Ableitung der Jitterfrequenz erfolgt vorzugsweise vom Oszillatorsignal S2 oder vom Referenzsignal S1N am Eingang des Phasendetektors 6.

Der Fall voreilender Phasenlage des Signals S2 gegenüber S1 ist in Figur 3b dargestellt. Das Signal S1 (A=1) entsteht nun häufiger (beispielsweise zu 90%) als das gestrichelt gezeichnete Signal S1 (A=0), da die Abtastung von S1 durch S2 häufiger bei "0" vor der ansteigenden Signalflanke als bei "1" nach der Signalflanke erfolgt. Nach Jittermodulation durch die Jitter-Modulationsschaltung 3 enthält das Signal S1 (A, J) die 3 Phasenlagen t=0 mit 5% Wahrscheinlichkeit, t=T2 mit 50% Wahrscheinlichkeit und t=2T2 mit 45% Wahrscheinlichkeit. Der Phasendetektor, der eine zur mittleren Phasendifferenz proportionale Steuerspannung erzeugt, wird daher eine Ziehspannung an den spannungsgeregelten Oszillator 11 abgeben, der die voreilende Phasenlage von S2 vermindert und dieses Signal an die Flanke von S1 heranführt, bis der in Figur 3a gezeigte Gleichgewichtszustand wieder erreicht ist. So können mit dem erfindungsgemäßen Phasenregelkreis Phasenzeitfehler erfaßt und ausgeregelt werden, die wesentlich geringer sind als die Periode T2 des Abtastsignals S2. Der verbleibende Phasenzeitfehler wird durch die Schaltflanken der Jitter-Modulation bestimmt.

Es kann so ein Phasenzeitfehler realisiert werden, der bei 10% oder weniger der Periodendauer T2 des Signals S2 liegt.

In Figur 5c ist der Fall nacheilender Phasenlage des Signals S2 gegenüber dem Signal S1 dargestellt. Die Abtastung erfolgt hier häufiger nach der ansteigenden Flanke von S1, so daß das Signal S1 (A=0) häufiger als S1 (A=1) entsteht. Analog wie in dem in Figur 3b diskutierten Fall erzeugt der Phasendetektor im Mittel eine Steuerspannung, die die Frequenz des Oszillators erhöht und so die nacheilende Phasenlage von S2 verringert und an die Flanke des Signals S1 heranführt.

Ein modifiziertes Ausführungsbeispiel des Phasenregelkreises von Figur 1 ist in Figur 2 dargestellt. Die Abtastschaltung 2 ist durch ein erstes D-Flipflop 13 realisiert, dessen C-Eingang mit dem Signal S2 versorgt wird. Mit dem Ausgang des D-Flipflops 13 ist ein zweites D-Flipflop 14 verbunden, das eine Signalverzögerung um T2 erzeugt. Der Ausgang des ersten Flipflops 13 ist mit einem ersten Eingang eines Multiplexers 15 und der Ausgang des zweiten Flipflop mit einem zweiten Eingang B des Multiplexers 15 verbunden. Der Multiplexer 15 dient als Schalteinrichtung, um abwechselnd zwischen dem nicht verzögerten Signal S1 (A, J = 0) und dem verzögerten Signal S1 (A, J = 1) umzuschalten. Die Umschaltfrequenz fj=f1/2N wird vom Signal S1N abgeleitet, so daß nur noch ein Frequenzteiler 16 benötigt wird, der die Frequenz des Signals S1N durch 2 teilt.

Aus Figur 2 wird deutlich, daß der Aufwand digitaler Logikschaltungen zur Realisierung eines erfindungsgemäßen Jitter-Modulators sehr gering ist, es werden nur ein Multiplexer sowie zwei D-Flipflops benötigt. Der verbleibende Phasenzeitfehler entspricht hier der Setup- und Holdzeit der beiden D-Flipflops 13 und 14.

**Patentansprüche**

1.  Phasenregelkreis zur Regelung der Phase eines Ausgangssignals S2 in Abhängigkeit von einem Referenzsignal S1, aufweisend:

    eine Abtastschaltung (2; 13) zur Abtastung des Referenzsignals S1 durch das Ausgangssignal S2 und zur Erzeugung eines Abtastsignals S1A,
    eine Jitter-Modulationsschaltung (3) zur Erzeugung eines um eine festgelegte Zeitdauer verzögerten Abtastsignals S1AJ und zur abwechselnden Ausgabe des unverzögerten Abtastsignals S1A und des verzögerten Abtastsignals S1AJ,
    einen Phasendetektor (6) zur Erfassung einer mittleren Phasendifferenz zwischen dem Ausgangssignal S2 und den verzögerten und unverzögerten Abtastsignalen S1A und S1AJ,

einen regelbaren Oszillator (11) zur Erzeugung des Ausgangssignals S2 mit einer in Abhängigkeit von der durch den Phasendetektor (6) erfaßten mittleren Phasendifferenz regelbaren Frequenz.

2. Phasenregelkreis nach Anspruch 1,
**dadurch gekennzeichnet,**

daß die Jitter-Modulationsschaltung (3) eine Verzögerungsschaltung (14) zur Erzeugung des verzögerten Referenzsignals S1AJ und eine Schalteinrichtung (15) zur abwechselnden Zuführung des unverzögerten Referenzsignals S1A und des verzögerten Referenzsignals S1AJ zu dem Phasendetektor (6) aufweist.

3. Phasenregelkreis nach Anspruch 2,
**dadurch gekennzeichnet,**

daß die Schalteinrichtung (15) ein digitaler Multiplexer ist.

4. Phasenregelkreis nach Anspruch 2 oder 3,
**dadurch gekennzeichnet,**

daß die durch die Verzögerungsschaltung (14) erzeugte Signalverzögerung einer Periodendauer T2 des Ausgangssignals S2 entspricht.

5. Phasenregelkreis nach einem der Ansprüche 2 bis 4,
**dadurch gekennzeichnet,**

daß die Schaltfrequenz der Schalteinrichtung (15) derart groß im Verhältnis zur Übertragungsfunktion des Phasenregelkreises (1) ist, daß das Schaltsignal von der Schalteinrichtung (15) im Ausgangssignal S2 weitgehend unterdrückt ist.

6. Phasenregelkreis nach einem der Ansprüche 1 bis 5,
**gekennzeichnet durch**

einen ersten Frequenzdividierer (4) zur Frequenzdivision des Referenzsignals S1 vor Zuführung zu dem Phasendetektor (6) durch N und/oder einen zweiten Frequenzdividierer (7) zur Frequenzdivision des Ausgangssignals S2 vor der Zuführung zu dem Phasendetektor (6) durch M, wobei N und M ganze Zahlen größer gleich 1 sind.

7. Phasenregelkreis nach Anspruch 6,
**dadurch gekennzeichnet,**

daß die Schaltperiode der Schalteinrichtung 2N mal der Taktperiode T2 des Ausgangssignals S2 ist.

8. Phasenregelkreis nach einem der Ansprüche 2 bis 7,
**dadurch gekennzeichnet,**

daß die Verzögerungsschaltung (14) ein durch das Ausgangssignal S2 angesteuertes digitales D-Flipflop aufweist.

9. Phasenregelkreis nach einem der Ansprüche 1 bis 8,
**dadurch gekennzeichnet,**

daß die Abtastschaltung (2; 13) ein D-Flipflop aufweist.

10. Phasenregelkreis nach einem der Ansprüche 1 bis 9,
**dadurch gekennzeichnet,**

daß das Tastverhältnis des dem Phasendetektor (6) zugeführten unverzögerten Referenzsignals S1A und des verzögerten Referenzsignals S1AJ 1:1 beträgt.

11. Phasenregelkreis nach einem der Ansprüche 1 bis 10,
**dadurch gekennzeichnet,**

daß der regelbare Oszillator (11) ein spannungsgesteuerter Quarzoszillator ist.

FIG 1

S2
(f2)

11  VCXO

10  D/A

9  Σ

8

6  PD

7  ./.M

S2M

5  Σ

+  −

1

S1N(A,J)

4  ./.N

S1(A,J)

3

S1(A)

S2

2

S1

FIG 2

**FIG 3A**

S2

S1

S1(A=0)
S1(A=1)

S1N(A=0, J=0)
S1N(A=1, J=0)

S1N(A=0, J=1)
S1N(A=1, J=1)

S2M

T2

w=25%
w=25%

w=25%
w=25%

}w=50%

**FIG 3B**

Δt

S2

S1

S1N(A=0, J=0)
S1N(A=1, J=0)

S1N(A=0, J=1)
S1N(A=1, J=1)

S2M

w=5%
w=45%
w=5%
w=45%

}w=50%

**FIG 3C**

Δt

S2

S1

S1N(A=0, J=0)
S1N(A=1, J=0)

S1N(A=0, J=1)
S1N(A=1, J=1)

S2M

w=45%
w=5%

w=45%
w=5%

}w=50%

# FIG 4

# FIG 5

Phasenzeitfehler x (t)

$\Delta x = T2$

Beobachtungszeit t

# FIG 6A

t = t0:  S1, S2, S1N, S2M, T2, t

# FIG 6B

t = t1:  S1, S2, S1N, S2M, T2, x, t

# FIG 6C

t = t2:  S1, S2, S1N, S2M, T2, x=T2, t

Europäisches
Patentamt

**EUROPÄISCHER RECHERCHENBERICHT**

Nummer der Anmeldung

EP 00 10 2996

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int.Cl.7) |
|---|---|---|---|
| Y | EP 0 847 142 A (NIPPON ELECTRIC CO) 10. Juni 1998 (1998-06-10) * Spalte 6, Zeile 34 - Spalte 9, Zeile 10 * | 1-11 | H03L7/08 |
| Y | EP 0 844 761 A (SIEMENS AG) 27. Mai 1998 (1998-05-27) * das ganze Dokument * | 1-11 | |
| A | WO 95 34127 A (SIERRA SEMICONDUCTOR CORP) 14. Dezember 1995 (1995-12-14) * das ganze Dokument * | | |
| A | US 5 126 693 A (GULLIVER WILLIAM H ET AL) 30. Juni 1992 (1992-06-30) * das ganze Dokument * | | |
| | | | RECHERCHIERTE SACHGEBIETE (Int.Cl.7) |
| | | | H03L |

Der vorliegende Recherchenbericht wurde für alle Patentansprüche erstellt

| Recherchenort | Abschlußdatum der Recherche | Prüfer |
|---|---|---|
| MÜNCHEN | 23. Mai 2000 | Kahn, K-D |

KATEGORIE DER GENANNTEN DOKUMENTE

X : von besonderer Bedeutung allein betrachtet
Y : von besonderer Bedeutung in Verbindung mit einer
    anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder
    nach dem Anmeldedatum veröffentlicht worden ist
D : in der Anmeldung angeführtes Dokument
L : aus anderen Gründen angeführtes Dokument
.................................................................
& : Mitglied der gleichen Patentfamilie, übereinstimmendes
    Dokument

EPO FORM 1503 03.82 (P04C03)

## ANHANG ZUM EUROPÄISCHEN RECHERCHENBERICHT
## ÜBER DIE EUROPÄISCHE PATENTANMELDUNG NR.

EP 00 10 2996

In diesem Anhang sind die Mitglieder der Patentfamilien der im obengenannten europäischen Recherchenbericht angeführten Patentdokumente angegeben.
Die Angaben über die Familienmitglieder entsprechen dem Stand der Datei des Europäischen Patentamts am
Diese Angaben dienen nur zur Unterrichtung und erfolgen ohne Gewähr.

23-05-2000

| Im Recherchenbericht angeführtes Patentdokument | | | Datum der Veröffentlichung | Mitglied(er) der Patentfamilie | | | Datum der Veröffentlichung |
|---|---|---|---|---|---|---|---|
| EP 0847142 | A | | 10-06-1998 | JP | 2947192 | B | 13-09-1999 |
| | | | | JP | 10163860 | A | 19-06-1998 |
| | | | | US | 5877658 | A | 02-03-1999 |
| EP 0844761 | A | | 27-05-1998 | KEINE | | | |
| WO 9534127 | A | | 14-12-1995 | US | 5917352 | A | 29-06-1999 |
| US 5126693 | A | | 30-06-1992 | KEINE | | | |

EPO FORM P0461